# EUROPEAN PATENT APPLICATION

(11) **EP 4 657 103 A2**
(43) Date of publication of application: **03.12.2025**
(21) Application number: 25208840.6
(22) Date of filing: 26.05.2023
(51) Int. Cl.: G01R 31/54

(54) **BATTERY MANAGEMENT SYSTEM AND MONITORING DEVICES**

(30) Priority: 29.05.2022 GB 202207923
(62) Divisional of application: 23730029.8
(71) Applicant: Dukosi Limited, Edinburgh EH3 8RA (GB)
(72) Inventor: MCVEIGH, Gavin, Edinburgh, EH3 8RA (GB); JACKSON, Angus, Edinburgh, EH3 8RA (GB); QUINN, Simon, Edinburgh, EH3 8RA (GB); FOSTER, Simon, Edinburgh, EH3 8RA (GB); BALLANY, Ross, Edinburgh, EH3 8RA (GB); BUCK, Kevin, Edinburgh, EH3 8RA (GB); MORRIS, Tim, Edinburgh, EH3 8RA (GB); GOLDFINCH, Jon, Edinburgh, EH3 8RA (GB); YUI, Chun Lai, Edinburgh, EH3 8RA (GB)
(74) Representative: Finnegan Europe LLP

(57) **Abstract**

A monitoring device is provided. The monitoring device comprises one or more circuitry operable to obtain measurements of one or more pins of a battery system, the one or more circuitry comprising at least one circuit for monitoring current, which comprise: at least one other circuit for amplifying variance comprising at least one differential amplifier, one voltage reference in electrical connection with a first input of the differential amplifier; at least one transconductance means comprising at least one output in electrical connection with a second input of the differential amplifier and at least one input in electrical connection with an output of the differential amplifier; at least one current source in electrical connection with at least one output of the at least one transconductance means; and an output in electrical connection with at least one output of the at least one transconductance means.

## Description

### Technical Field

The present disclosure relates to the field of battery technology and energy cells. More specifically the present disclosure relates to battery management systems and monitoring devices for monitoring battery cells or groups of battery cells, and regulation systems for use with such monitoring devices.

### Background

Battery systems, comprising a plurality of battery cells, are used in a wide range of modern electric power applications. For example, they are used to power electric vehicles, they are used in industrial power applications, in transportation, and in commercial applications such as powering of modem electronic devices. Given the relatively high-power demands of such applications, a battery system often comprises multiple battery cells coupled together to achieve the required power output. The battery cells may be coupled together to form a battery pack, and the battery system may comprise one or more battery packs.

It is common to connect a battery system to a battery management system, configured to ensure that the battery system operates within its safe operating range. The safe operating area is commonly defined as the voltage, temperature and current conditions under which the battery system is expected to operate without self-damage.

To achieve this typically each battery cell in a battery system is monitored using a cell monitoring device. The function of the cell monitoring device is to measure signals from the battery cells being monitored such as cell terminal voltage, the cell current, the cell temperature, cell pressure, etc., which are then used to determine if the cell is in a safe state. In some systems, measurements made by a cell monitoring device are collated and transmitted to a battery management system which processes the measurements to determine the current state of a cell being monitored. Alternatively, measurements may be collated and processed within the individual cell monitoring devices and reported to a battery management system so that the battery management system can maintain an overview of the current state of the battery system.

### SUMMARY

An aspect of the present disclosure provides a monitoring device operable to report sensor measurements in a battery system. The monitoring device comprises one or more circuitry operable to obtain measurements of one or more pins of a battery system, and the one or more circuitry comprise at least one circuit for monitoring current. At least one circuit for monitoring current comprises: at least one other circuit for amplifying variance comprising at least one differential amplifier, one voltage reference in electrical connection with a first input of the differential amplifier, the differential amplifier further comprising a second input and an output; at least one transconductance means comprising at least one output in electrical connection with the second input of the differential amplifier and at least one input in electrical connection with the output of the differential amplifier; wherein the second input of the differential amplifier and at least one output of the at least one transconductance means is in electrical connection with the one or more pins of a battery system; at least one current source in electrical connection with at least one output of at least one of the at least one transconductance means; and an output in electrical connection with at least one output of at least one of the at least one transconductance means; wherein the at least one circuit for monitoring current is operable to detect a disruption in or an absence of an electrical connection of a sensor connected to the one or more pins by monitoring a current required to cause a variance in a voltage on the one or more pins.

An aspect of the present disclosure provides a regulation system for providing a regulated voltage during a power on reset to a cell monitoring device (CMD) of an electric battery system. The electric battery system comprises at least one pack, each pack comprising a plurality of battery cells, wherein each battery cell is monitored via a respective CMD. The regulation system comprises a bandgap reference unit configured to generate a bandgap reference voltage (VBG) based on a supply voltage (VDD), and further configured to generate a first enablement signal once the bandgap reference voltage is stable and at a level suitable for operational safety of the CMD core circuit. The system further comprises a voltage regulator unit configured to receive the bandgap reference voltage (VBG) and the first enablement signal from the bandgap reference unit, and upon receipt of the first enablement signal, the voltage regulation unit further configured to generate the regulated voltage (D_{VDD}), for powering the CMD core circuitry, where the regulated voltage (D_{VDD}) is generated based on a comparison of the bandgap reference voltage (VBG). The system additionally comprises a power on reset comparator configured to receive the bandgap reference voltage (VBG) from the bandgap reference unit and the regulated voltage (D_{VDD}) from the voltage regulator. The power on reset comparator is further configured to provide a second enablement signal to the CMD core circuit once a value of the regulated voltage is greater than a value of the bandgap reference voltage (VBG), where the second enablement signal enables the CMD core circuit to access the regulated voltage (D_{VDD}).

Another aspect of the present disclosure provides a method in a regulation system for providing a regulated voltage during a power on reset to a cell monitoring device (CMD) of an electric battery system. The electric battery system comprises at least one pack, each pack comprising a plurality of battery cells, where each battery cell is monitored via a respective CMD. The method comprises generating, via a bandgap reference unit (BG), a bandgap reference voltage (VGB) based on a supply voltage (VDD), and further generating a first enablement signal once the bandgap reference voltage (VBG) is stable and at a level suitable for operational safety of CMD core circuit 305. The method further comprises receiving, via voltage regulator unit 301, the bandgap reference voltage (VBG) and the first enablement signal from the bandgap reference unit. Upon receipt of the first enablement signal, the method further comprises generating, via the voltage regulator unit, the regulated voltage (D_{VDD}) for powering the core circuitry of the CMD, where the regulated voltage (D_{VDD}) is generated based on a comparison of the bandgap reference voltage (VBG). The method also comprises receiving, via a power on reset comparator, the bandgap reference voltage (VBG) from the bandgap reference unit and the regulated voltage (D_{VDD}) from the voltage regulator. The method additionally comprises providing, via the power on reset comparator, a second enablement signal to the CMD core circuit once a value of the regulated voltage (D_{VDD}) is greater than a value of the bandgap reference voltage (VBG), where the second enablement signal enables the CMD core circuit to access the regulated voltage (D_{VDD}).

Further aspects of the present disclosure provide monitoring devices, monitoring systems, controllers, and regulation systems for use in systems such as those described above, and methods relating thereto.

### BRIEF DESCRIPTION OF THE DRAWINGS

The foregoing will be described in more detail with the following more particular description of example embodiments, as illustrated in the accompanying drawings in which reference characters refer to the same parts throughout the different views. The drawings are not necessarily to scale, emphasis instead being placed upon illustrating the example embodiments.
**FIG. 1** is a schematic illustration of an exemplary wired battery management system architecture in which a plurality of cell monitoring devices are connected to a communications controller via a wired harness in the form of a star network;
**FIG. 2** is a schematic illustration of an exemplary wired battery management system architecture in which a plurality of cell monitoring devices are connected to a communications controller via a wired harness in the form of a daisy chained network;
**FIG. 3** is a schematic illustration of an exemplary battery management system architecture in which a plurality of cell monitoring devices and a communications controller are connected via a wireless communications network;
**FIG. 4** is a schematic block diagram of an exemplary cell monitoring device and a communications controller of the battery management system of Figure 3.
**FIG. 5** is a schematic block diagram of an alternative exemplary cell monitoring device and communications controller of the battery management system of Figure 3.
**FIG. 6** is a schematic illustration of a circuit for monitoring current of an exemplary sensor operable to obtain measurements of one or more pins of a battery system, according to some of the example embodiments described herein.
**FIG. 7** is a schematic illustration of first and second circuits for monitoring current of an exemplary sensor operable to obtain measurements of one or more pins of a battery system, according to some of the example embodiments described herein.
**FIG. 8** is a schematic illustration of a circuit for monitoring current of an exemplary sensor operable to obtain measurements of one or more pins of a battery system, according to some of the example embodiments described herein.
**FIG. 9** is a schematic illustration of an exemplary regulation system for providing a regulated voltage during a power on reset to a cell monitoring device, according to some of the example embodiments described herein.
**FIG. 10** is a schematic illustration of an exemplary bandgap reference unit of **FIG. 9****,** according to some of the example embodiments described herein.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of systems, apparatuses and methods consistent with aspects related to the invention as recited in the appended claims.

### Overview of battery management system architectures

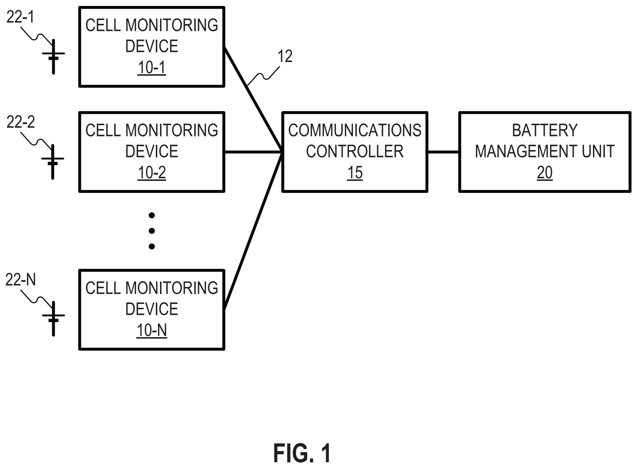

Figure 1 is an illustration of an exemplary wired battery management system architecture in which a plurality of cell monitoring devices 10-1...10-N are connected via wired harness 12 to communications controller 15. In the exemplary architecture of Figure 1, wired harness 12 connects cell monitoring devices 10-1...10-N to communications controller 15 in the form of a star network with communications controller 15 at its centre. Communications controller 15 is also connected to battery management unit 20.

In the exemplary system of Figure 1, each cell monitoring device 10-1...10-N is configured to monitor one or more battery cells 22-1...22-N and obtain measurements of physical characteristics associated with one or more cells 22-1...22-N, such as voltage, current, temperature, pressure, strain, force etc. and/or derived measures such as State of Charge (SoC). These measurements (which in some examples, may include derived measures) are then transmitted from each cell monitoring device 10-1...10-N to communications controller 15 via wired harness 12.

Communications controller 15 may be arranged to aggregate all messages from cell monitoring devices 10-1...10-N and then pass them to battery management unit 20, or alternatively communications controller 15 may be configured to pass individual messages directly to battery management unit 20 which then proceeds to process received measurements to determine a current state of the battery system.

Often communications controller 15 will be a separate hardware device from battery management unit 20. Alternatively, communications controller 15 and battery management unit 20 may be integrated into a single hardware device in which communications controller 15 is responsible for co-ordinating receipt of data via wired harness 12 and battery management unit 20 is responsible for analysis and processing of data.

One drawback of the wired battery management system architecture illustrated in Figure 1 is that in such an architecture, communications controller 15 and wired harness 12 are configured to receive measurements from a pre-defined number of cell monitoring devices 10-1...10-N. This makes expansion of the system difficult as addition of additional cell monitoring devices 10-1...10-N will normally require addition of extra circuitry and connectors to communications controller 15 to connect to additional cell monitoring devices as well as modification of wired harness 12.

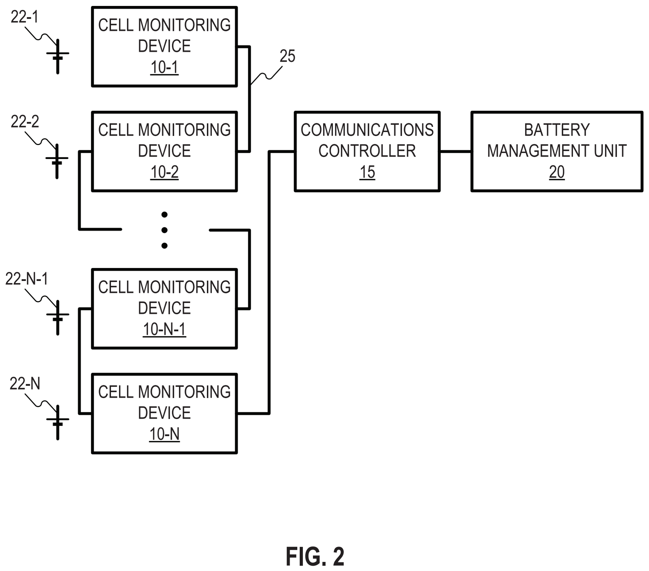

Figure 2 shows an alternative approach to the wired battery management system architecture of Figure 1. In contrast to the wired battery management system architecture in Figure 1 in which wired harness 12 connects cell monitoring devices 10-1...10-N to communications controller 15 in the form of a star network, in the exemplary architecture of Figure 2, cell monitoring devices 10-1...10-N are wired by wiring 25 in the form of a daisy-chain network in which successive cell monitoring devices 10-1...10-N are connected in series.

Operation of the wired battery management system architecture of Figure 2 is very similar to the operation of the star network of Figure 1, except that rather than each cell monitoring device 10-1...10-N communicating directly with communications controller 15, messages are conveyed to and from cell monitoring devices 10-1...10-N by being relayed up and down daisy-chain wiring 25. This means operation of each cell monitoring device 10-1...10-N is no longer identical, since cell monitoring device 10-N with a direct connection to communications controller 15 must relay messages from all other cell monitoring devices 10-1...10-N-1 while cell monitoring device 10-1 at the end of the daisy chain has no message relay demands. The latency on a message (how long it takes to travel from a source cell monitoring device to communications controller 15) varies from cell monitoring device to cell monitoring device and increases as the number of cells/cell monitoring device increases. In some embodiments, daisy-chain wiring 25 can be formed into a loop terminating at communications controller 15 at both ends. In this case, latency can vary between cell monitoring devices 10-1...10-N depending on the direction around the loop that messages travel. This variable latency is a drawback of daisy-chain wired battery networks.

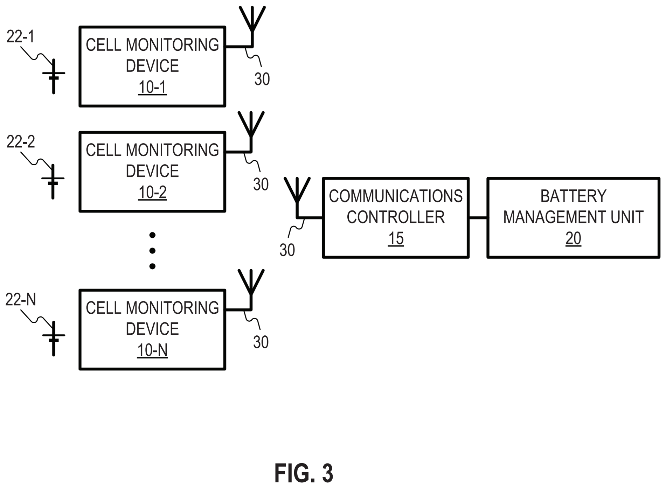

Figure 3 shows a variation of the battery management system architecture of Figure 1, but instead of using wired harness 12, communications are made wirelessly via a radio network. To that end, each cell monitoring device 10-1...10-N has an antenna 30, as does communications controller 15. The radio network may use far field antenna or near-field coupling.

The wireless battery management system architecture of Figure 3 has the advantages of a wired star network (all cell monitoring devices 10-1...10-N are identical, constant latency etc.). Additionally, neither communications controller 15, nor any wired harness 12 needs to be modified as the number of cell monitoring device 10-1...10-N changes. However, wireless communications generally can be less reliable than wired networks, due to the unpredictability of the radio channel and external radio energy sources causing interference with communications.

### Structure of communications controller and cell monitoring devices

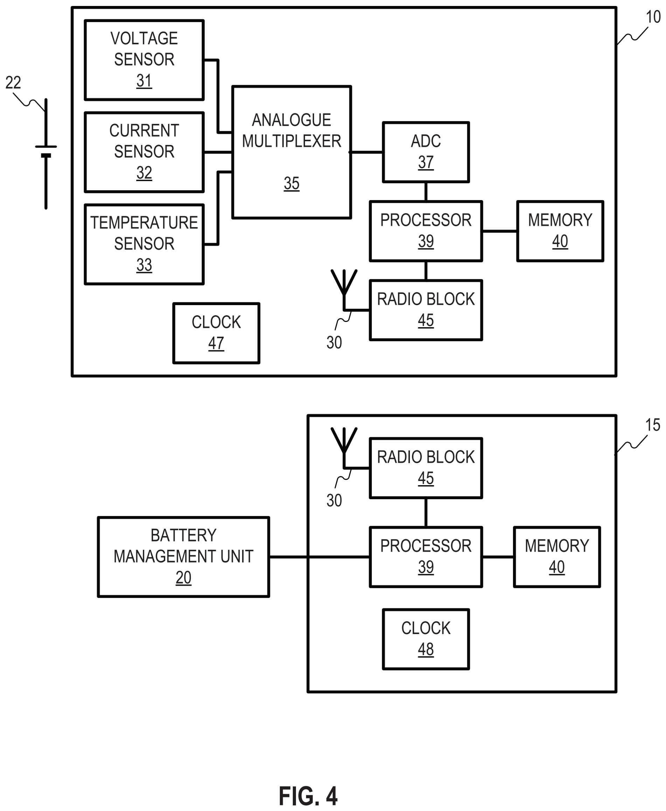

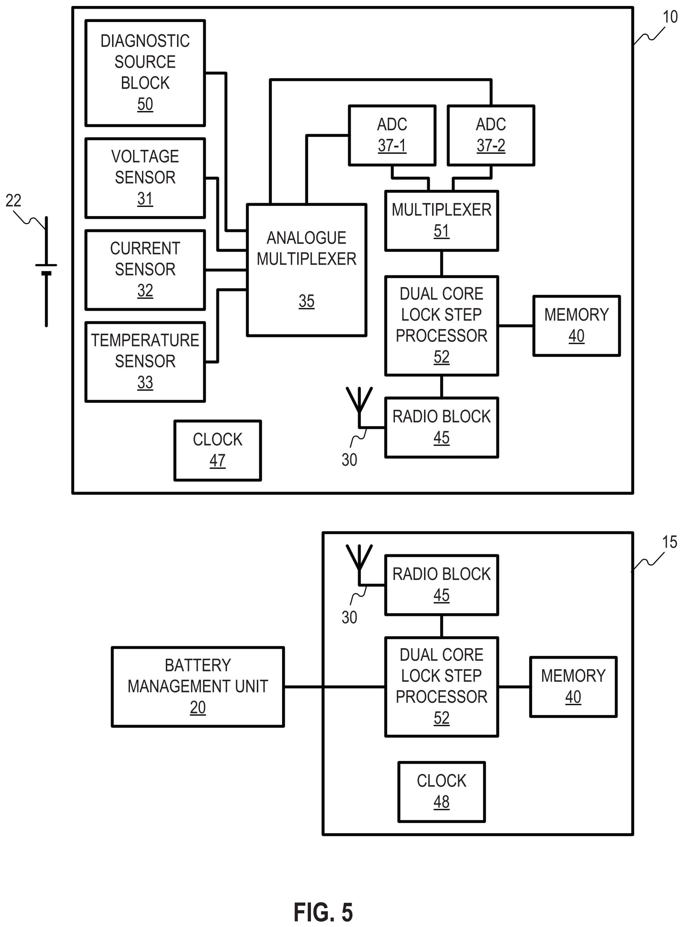

The structure of communications controller 15 and cell monitoring devices 10-1...10-N of the system of Figure 3 will now be described in greater detail with reference to Figures 4 and 5.

Turning first to Figure 4, in an embodiment, cell monitoring device 10 of battery management system of Figure 3 may comprise one or more sensors 31, 32, 33. In Figure 4, three sensors: voltage sensor 31, current sensor 32 and temperature sensor 33 are shown. It will be appreciated that in other embodiments, more or fewer or different sensors might be included in cell monitoring device 10.

In this embodiment, sensors 31, 32, 33 are connected via analogue multiplexer 35 to analogue to digital convertor (ADC) 37 which is also connected to processor 39. In alternative embodiments, analogue multiplexer 35 could be omitted and instead multiple ADCs 37 could be provided with each of the sensors being connected to processer 39 directly via its own dedicated ADC 37. It will, however, be appreciated that the provision of analogue multiplexer 35 enables the duplication of ADCs 37 to be avoided.

Processor 39 is also connected to memory 40 which may be non-volatile random-access memory (NVRAM) or read only memory (ROM) which stores a program comprising processing instructions for processing digital signals representing sensor measurements received from ADC 37. Alternatively, memory 40 may comprise static random-access memory (SRAM) enabling a program to be stored and then subsequently modified. Such embodiments may facilitate the creation and debugging of programs for storage in a cell monitoring device 10 during development of a battery management system.

In addition, processor 39 is also connected to antenna 30 via radio block 45. Clock 47 is provided within cell monitoring device 10 to co-ordinate timing of sensor measurements and other processes undertaken by cell monitoring device 10. In some embodiments clock 47 may take the form of an oscillator.

In use, sensors 31, 32, 33 take measurements from one or more battery cells 22 (only one battery cell 22 is shown in Figure 4, but typically in embodiments monitoring device 10 may be arranged to obtain measurements from multiple battery cells e.g. groups of 12 or more). Analogue measurements from sensors 31, 32, 33 are passed via analogue multiplexer 35 to ADC 37 which sends a digitised measurement to processor 39. Processor 39 then runs a program stored in memory 40 that transforms the received digital signal into a measurement value that has physical meaning, such as Volts, Amps, Kelvin, etc., and packages the data ready for transmission. In embodiments packaged digitized measurements may be retained within internal registers within processor 39 prior to transmission. Periodically radio block 45 is activated which causes the stored packaged measurements stored internally within registers within processor 39 to be transmitted wirelessly via antenna 30 to communications controller 15.

The structure of communications controller 15 is similar to that of cell monitoring device 10 in that communications controller 15 also comprises antenna 30, radio block 45, processor 39, memory 40, and clock 48. However, rather than storing a program which co-ordinates the capture, packaging and transmission of sensor measurements from sensors 31, 32, 33, memory 40 in communications controller 15 stores a program which causes processor 39 of communications controller 15 to co-ordinate transfer of the measurement data to battery management unit 20. Processor 39 of communications controller 15 may, in some embodiments, detect an error in the transmission, reception and/or packaging of sensor measurements before transferring measurement data to battery management unit 20. Such processing may involve the checking of an error detection or error correction code included in transmissions received via antenna 30. In addition, communications controller 15 also provides a communications path for control messages to be sent from battery management unit 20 via antennas 30 and a wireless communications link to cell monitoring devices 10-1...10-N. Communications controller 15 may, in some embodiments, generate and send control messages to cell monitoring devices 10-1...10-N via antennas 30.

Although the architecture of cell monitoring device 10 and communications controller 15 shown in Figure 4 may be satisfactory for low-risk applications, such an architecture is unsuitable for high-risk applications as there are numerous points of unreliability in the illustrated architecture.

By way of example a fault in ADC 37 may go undetected. Alternatively, a fault in a software program may go undetected. "Stuck at" faults may occur at numerous locations, where a value which should change is not updated. If an ADC 37 output value fails to be updated, the system may not notice that the value fails to change. Meanwhile, a cell may have gone over voltage, creating a hazard. Processor software may fail to update a value being sent to radio block 45, so communication controller 15 receives what looks like a safe value, but which is actually incorrect.

In view of these issues, in many applications an alternative architecture as is illustrated in Figure 5 may be used.

Compared with the architecture of Figure 4, in the alternative architecture of Figure 5, diagnostic source block 50 is included in cell monitoring device 10 which is arranged to apply known signals to analogue multiplexer 35. If a known value, or a predicted value based on the known value, is not then subsequently seen by the processor of monitoring device 10 or communications controller 15, then that can be an indicator of something having gone wrong and a fault will have been detected.

Further, the architecture of Figure 5 replaces ADC 37 with multiplexer 51 connected to two ADCs 37 -1, 37-2. It is unlikely (i.e. there is a low likelihood) that both ADCs 37-1, 37-2 will simultaneously display the same fault. Hence outputs from ADCs 37 -1, 37-2 may be compared, and if they are not substantially in agreement (i.e. the obtained ADC conversions substantially correspond) the fault can be flagged. Ordinarily, in such circumstance, if there is a disagreement between the results of ADCs 37-1, 37-2, it will normally only be possible to determine that one of ADCs 37-1, 37-2 is at fault, but not which one. However, in some embodiments it may be possible to identify which of ADCs 37-1, 37-2 is in error in combination with a diagnostics source (e.g. a known value or a predicted value based on the known value from diagnostic source block 50). A further potential benefit of the presence of two ADCs 37-1, 37-2 is that the outputs of ADCs 37-1, 37-2 which are in substantial agreement (i.e. the obtained values do not disagree by more than a threshold amount) may be averaged to obtain an averaged value of a digitized sensor signal. This may increase the accuracy of analogue to digital conversion of a measured analogue signal as it will reduce the impact of noise in the measurement and conversion process. In some embodiments, this may be preferable to merely truncating measured signals from a single ADC.

In addition to replacement of single ADC 37, with a pair of ADCs 37-1, 37-2 and multiplexer 51, in the architecture of Figure 5, processors 39 of monitoring device 10 and communications controller 15 are replaced with dual core lock step processors 52. Dual core lock step processors 52, sometimes called safety processors, are processors containing two (or more) processor cores, where each core runs the same software program, but one core is delayed relative to the other. Other than this delay, the two cores run in lock step. This enables the output of cores to be compared (with the delay accounted for). As the cores run the same program on the same data, results should agree exactly. Hence if one of the software programs is corrupted on one of the cores and results do not agree, a fault can be detected.

Although these modifications to the architecture of Figure 4 increase the ability to confirm that errors have not occurred during the conversion and transmission of sensor measurements from sensors 31, 32, 33 at cell monitoring device 10 to battery management unit 20, reliability of data received by battery management unit 20 can be further enhanced by restricting the processing undertaken by dual core lock step processors 52.

More specifically, the applicants have appreciated that software processing of data within a communications path between acquisition of analogue measurements by sensors 31, 32, 33 at cell monitoring devices 10-1...10-N and receipt of collected data at battery management unit 20 is a significant potential source of error within a battery management system. Hardwired data processing such as that undertaken by multiplexer 35 and ADCs 37-1, 37-2 is inherently deterministic. For example, as described above, it is possible to detect a fault or an error because the outcomes of hardwired data processing are predictable within a tolerance range. However, software processing, particularly where it is dependent upon factors external to a processor is not (e.g., because such external factors can lead to a wide-ranging outcomes, often leading an outcome from a number of possibilities which are, in practice, unpredictable until the processing has actually taken place). Examples of such external factors will include any processing based on interrupts which will alter expected processing by causing a particular process to be halted whilst a secondary process is undertaken. In addition, actions reliant upon non-deterministic external memory access (as opposed to storage of values within registers of a processor) may result in non-deterministic errors as may the use of a stack as stack overflow errors may occur at unexpected times. Conversely, when processing is deterministic and does not involve interrupts and external memory access steps etc. processing can be expected to run to completion within a set period and there would be expected to be comparatively little variation in the time taken to run a program to completion. This would not be the case where a program involves interrupt steps as such interrupts necessarily render the time taken for a program to run to completion uncertain as any interrupts result in the suspension of processing for an unknown period of time and the timing with which such interrupts are triggered will not be known in advance.

Although it may be possible to analyse software to "prove" that errors will not occur, such analysis is difficult, time consuming and expensive. The applicants have appreciated that much of the potential unreliability of software processing in the data path between a set of sensors 31, 32, 33 and battery management unit 20 can be reduced by applying a number of primary principles to the construction of programs to be run by processor 39, 52.

First as a matter of principle the processing of measurements from a set of sensors 31, 32, 33 should be restricted to the conversion of sensor measurements into meaningful digital data (e.g., conversion of sensor measurements into digital code to a measurement value that has physical meaning, such as Volts, Amps, Kelvin etc) and the packaging (including generation and checking of any error detection or error correction codes within data for transmission) of such data so that it can be transmitted to battery management unit 20 for analysis. Other processes, for example non-critical but potentially helpful processing such as the generation of histogram data representing time cells 22-1...22-N stay in a particular state should be performed via a separate processing path using a separate processor which is not responsible for the processing, packaging and transmission of sensor measurement data.

Secondly, programs to be executed as part of this data transmission path should be designed so as to avoid the use of any interrupts, external memory access steps involving storage or access of data within non-deterministic memory, or the use of a stack. This latter principle can be achieved if programs within the data transmission path are arranged to store data within internal registers of processor 39 rather than utilizing external memory storage in the course of processing and transmitting sensor data from sensors 31, 32, 33 to battery management unit 20 and the extent of programs which are to be run by processor 39, 52 are such that they are necessarily run to completion within a timescale which is smaller than the timescale with which sensor measurements are obtained and reported to battery management unit 20.

This latter criterion can be achieved where sensor measurements are sampled and reported to battery management unit 20 in accordance with a predetermined schedule and the processing power and clock speed of any processor 39, 52 within the data transmission path between sensors 31, 32, 33 and the battery management unit 20 is such that any program to be run by such processors 39, 52 within the data path are such that it will run to completion within shorter timescales than the timescales with which data is to be sampled and reported.

Thus, by way of example, where cell measurements are sampled and reported at a frequency of a number of Hertz and processor 39, 52 has a processing speed of the order of a number of mega-hertz, programs to be executed by processor 39, 52 need to be such that they are necessarily run to completion within a number of clock cycles less than the ratio between the sampling frequency and the processing speed of processor 39, 52. Although, this means that the processing power of processor 39, 52 will be under-utilized, this will ensure that each program executed by processor 39, 52 is completed and packaged data is available for transmission whenever it is required. This, together with the absence of the use of interrupts, external memory access or the use of a stack, is such to cause processor 39, 52 to operate as a deterministic state machine and as such will render the reliability of processing by processor 39, 52 comparable to the other hardwired components of cell monitors 10-1...10-N and communications controller 15.

In some examples, processor 39, 52 may be provided in the system (e.g., designed or fabricated) with following functionalities excluded: at least one or all of interrupt, external memory access and/or use of a stack. Alternatively, processor 39, 52 may be provided in the system with the above functionalities but those functionalities are disabled. Yet in other alternative embodiments, processor 39, 52 is provided in the system with the above functionalities but any program to be run thereon is designed so as to avoid using any of those functionalities.

Further it is preferable that the operations performed by processor 39, 52 within the communications path between ADC 37 or ADCs 37-1, 37-2 and battery management unit 20 are such that processing is limited to the conversion of the outputs of the ADCs into data and the packaging of such data inclusive of creation and appending of any error checking or error correction codes without the data representative of the sensor measurements being stored or modified. Preferably, the processing is limited to processing in accordance with a single set of instructions corresponding to this task. This should assist in ensuring that processors 39, 52 operation is identical each time the process is undertaken.

### Disruption or faulty connection detection using circuit for monitoring current

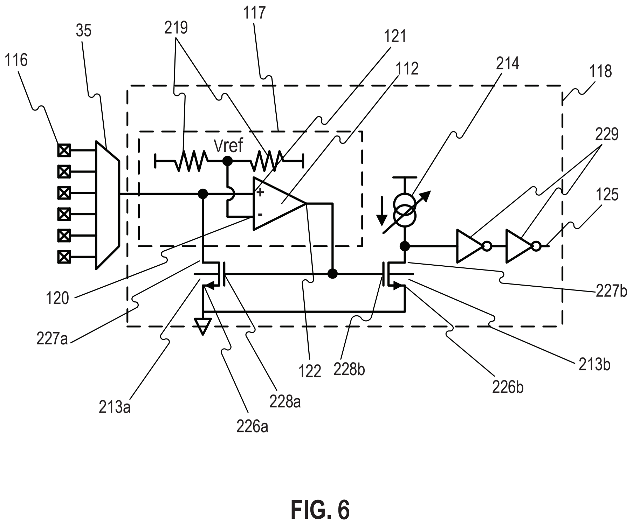

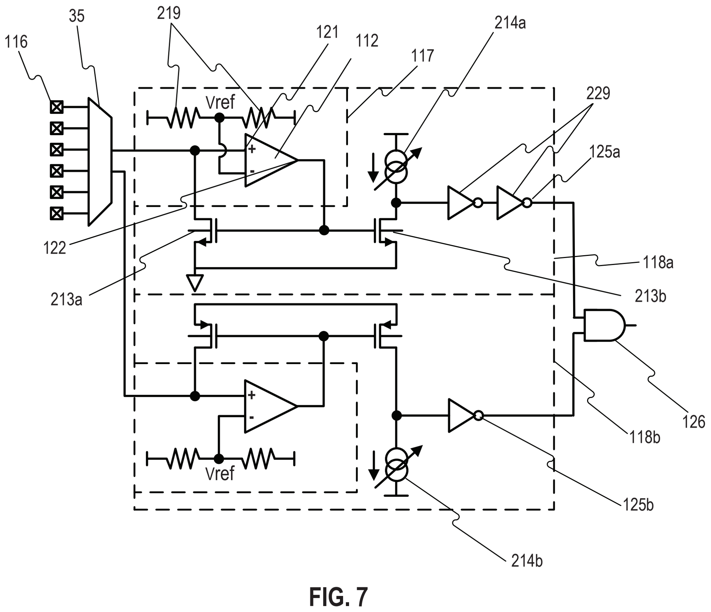

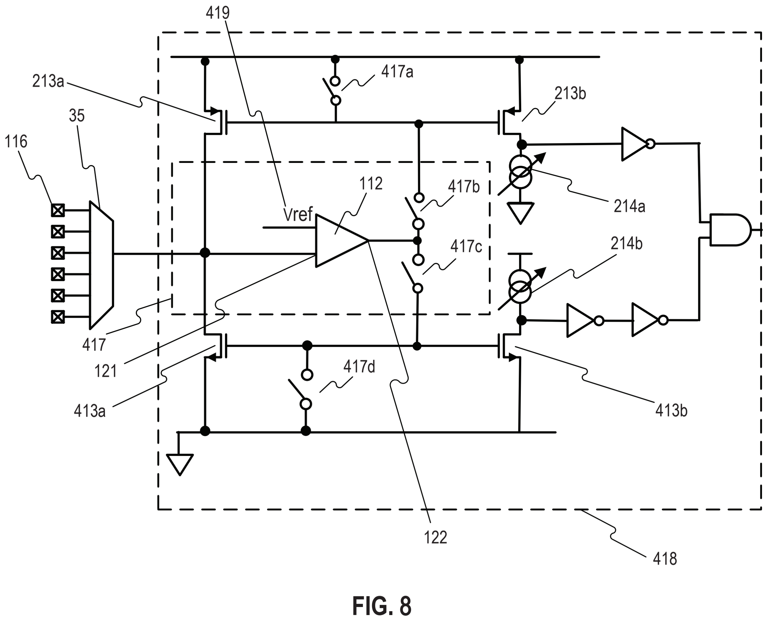

The following description relates to example circuitries of the present disclosure which comprise at least one circuit for monitoring current (for example, an injected current), wherein the at least one circuit is operable to detect a disruption to, or a fault in, a signal communication path, which may be caused by a faulty pin, for example. This disruption or fault detection might take the form of detecting, or identifying, an open circuit. For example, this open circuit may arise when a pin or a connection between cell monitoring device (CMD) and a sensor external to the CMD is broken, resulting in a voltage on the pin under this open circuit condition. The disruption or fault detection might take the form of detecting, or identifying, a short circuit, for example, typically between two neighbouring pins of the CMD. Such circuit for monitoring current can be configured to perform either open circuit detection (OCD) or short circuit detection (SCD) process as described below. For example, any one or more of circuit 118 in Figure 6, circuits 118a, 118b in Figure 7, and circuit 418 in Figure 8 may form part of an Open Circuit Detection circuit (OCD).

### Prior Systems

Previous systems for detecting an open or short circuit operate by varying current and observing a change in voltage. Such systems take a longer amount of time to determine an open or short circuit than systems using circuit for monitoring current described herein (for example, illustrated in Figure 6 to Figure 8). For example, the time taken might differ by approximately a factor of ten under like-for-like conditions in which all other variables are equal. The OCD and/or SCD related exemplary embodiments described herein provide at least a considerable time saving when detecting an open or short circuit, which can be an indication of presence of a disruption or a faulty connection.

### Open circuit detection (OCD) according to some exemplary embodiments

In some examples, an open circuit in a connection between a sensor (such as sensors 31, 32, 33 of exemplary battery management system in Figure 1 to Figure 5), which is connected to pin 116, and analogue multiplexer 35 can be identified by observing a current required to be injected into the connection in order to force, or drive, the connection to a defined voltage. In normal operation, no reasonable amount of current can force the connection voltage to vary much, as sensor 31, 32, 33 has too low an impedance. In the event of an open circuit, for instance due to a faulty pin, the connection will present a high impedance, and the connection voltage can then be moved or varied by injecting current into the connection.

Therefore, such circuit for monitoring injected current may be used on an electrical connection pin of sensor 31, 32, 33, which should have a normal impedance value within an operating impedance range, to detect a disruption or a faulty connection by identifying a fault or an error in the connection when the voltage on the electrical connection pin behaves in a certain way in response to an injected current which may be abnormal, or an expected response for a faulty connection.

In some examples, when such disruption or faulty connection is detected, this detection is reported to a device or a controller, for example, cell monitoring device 10, 10-1...10-N, diagnostic source block 50, communications controller 15, and/or battery management unit 20 of battery management system described herein or shown in Figure 1 to Figure 5, using the same process or method as how measurement data from sensors 31, 32, 33 are communicated. In some examples, data representative of an output signal from the circuit for monitoring current is communicated to a device or a controller, for example, cell monitoring device 10, 10-1...10-N, diagnostic source block 50, communications controller 15, and/or battery management unit 20 of battery management system described herein or shown in Figure 1 to Figure 5, using the same process or method as how measurement data from sensors 31, 32, 33 are communicated, so that the device or the controller can process the received data to determine whether disruption or a faulty connection has been detected. It is understood that according to some examples, circuit for monitoring current is implemented with Application Specific Integrated Circuits (ASIC).

Figures 6 to 8 and the schematic circuits illustrated therein provide examples of a circuit for monitoring current operable in this way. In some examples, such circuit for monitoring injected current may be part of one or more components (for example, those of a connected status sensor, or circuitry operable to obtain measurements of one or more pins of a battery system) that are arranged to have one or more electrical connections with another component, for example any component of exemplary battery management system in Figure 1 to Figure 5 such as exemplary cell monitoring device 10-1, 10-2,..., 10-N, communications controller 15, battery management unit 20, one or more sensors 31, 32, 33, ADC 37, 37-1, 37-2, and/or multiplexer 35, 51.

Figure 6 illustrates at least one circuit 118 for monitoring injected current according to some examples described herein. In some examples, circuit 118 may be a component of circuitry or cell monitoring device 10, 10-1...10-N, and may be operable to transmit, communicate and/or report its output, such as disruption detection, fault detection, or connected status sensor measurement to a controller (e.g., communications controller 15 or battery management unit 20) in a battery system (not shown).

Such circuitry comprising at least one circuit for monitoring current as described herein, may be operable to obtain measurements (for example, voltage measurements) of one or more pins 116 of battery system. In some examples, sensors 31, 32, 33 (not shown) of exemplary battery management system in Figure 1 to Figure 5 may comprise one or more internal circuitry for obtaining voltage measurements of one or more pins 116 and/or may comprise connections via device pins 116 to external circuitry and measurement points of a battery system (not shown). In some examples, sensors 31, 32, 33 (not shown) are external sensors electrically connectable, via one or more pins 116, to one or more circuitry for obtaining voltage measurements of one or more pins 116. One or more pins 116 may be connectable to one or more circuits 118, 118a, 118b, 418 via multiplexer 35 as in the examples illustrated in Figures 6 to 8 so that one or more electrical connections with one or more selected pins may be established by the one or more circuits 118, 118a, 118b, 418.

One or more circuitry illustrated in Figure 6 and Figure 7 comprise at least one circuit 118, 118a, 118b for monitoring current which may comprise at least one other circuit 117 for amplifying variance, which may itself comprise at least one differential amplifier 112, one voltage reference 219 (or a reference voltage source for providing a reference voltage Vref) in electrical connection with first input 120 of differential amplifier 112, wherein differential amplifier 112 also comprises second input 121 and output 122.

At least one circuit 118, 118a, 118b (e.g., circuit for OCD) may also comprise at least one transconductance means 213a, 213b, which may comprise at least one output 227a in electrical connection with second input 121 of differential amplifier 112 and at least one input 228a, 228b in electrical connection with output 122 of differential amplifier 112. Transconductance means 213a, 213b may be arranged in circuit 118 for monitoring injected current such that it converts a voltage on input 228a, 228b to a current on output 227a, 227b.

Second input 121 of differential amplifier 112 and at least one output 227a of at least one transconductance means may also be configured to be in electrical connection with one or more pins 116 of a battery system, for example via multiplexer 35. One or more pins 116 may provide an electrical connection with modules or cells of the battery system and/or may provide an electrical connection to external measurement points (not shown), for example, to one or more sensors 31, 32, 33. Analogue multiplexer 35 may be operable to select at least one of one or more pins 116 and electrically connect only the selected pin with at least one output 227a of at least one transconductance means.

At least one circuit 118 for monitoring current may also comprise at least one current source 214 in electrical connection with at least one output 227b of at least one of at least one transconductance means. Such current source 214 serves to provide a reference current.

At least one circuit 118 may also comprise output 125 in electrical connection with at least one output 227b of at least one of at least one transconductance means. At least one circuit 118 for monitoring current may then be operable to detect a disruption to, or an absence of, an electrical connection of a sensor connected to one or more pins 116 by monitoring a current required to cause a variance in a voltage on one or more pins 116.

Figure 6 illustrates a specific example in which at least one transconductance means comprises at least one transistor 213a, 213b. In the example illustrated in Figure 6, at least one transistor 213a, 213b comprises a pair of field effect transistors, for example first field effect transistor 213a and second field effect transistor 213b, each themselves comprising source terminal 226a, 226b, drain terminal 227a, 227b (functioning as an output of transconductance means) and gate terminal 228a, 228b (functioning as an input of transconductance means). First field effect transistor 213a and second field effect transistor 213b are arranged in parallel such that their respective gate terminals 228a, 228b are in electrical connection with each other and their respective source terminals 226a, 226b are in electrical connection with each other.

Output 122 of differential amplifier 112 is in electrical connection with gate terminals 228a, 228b of pair of field effect transistors 213a, 213b. Drain terminal 227a of first field effect transistor 213a is in electrical connection with second input 121 of differential amplifier 112.

In the example illustrated in Figure 6, at least one current source 214 is in electrical connection with drain terminal 227b of second field effect transistor 213b. In the examples illustrated in Figure 6 and Figure 7, at least one current source 214, 214a, 214b comprises a variable current source. It is understood that a constant current source or any other type of current source may be used instead in other examples, as long as it is able to provide a reference current, for example for a field effect transistor of transconductance means such as second field effect transistor 213b.

Circuit 118, 118a, 118b for monitoring current further comprises at least one output amplifier 229 arranged at output 125, 125a, 125b of circuit 118, 118a, 118b for monitoring current, wherein at least one output amplifier 229 may be implemented as at least one inverter.

In the examples illustrated in Figure 6 and Figure 7, voltage reference Vref is provided by two resistors 219 arranged in series. Such two resistors 219 may act as a voltage divider setting the reference voltage as a defined fraction of a power supply voltage.

In some examples, pair of field effect transistors 213a, 213b may comprise at least one pair of p-channel or n-type field effect transistors, which are also known as PMOS (p-channel metal-oxide semiconductor) or NMOS (n-type metal-oxide semiconductor) transistor respectively.

An exemplary operation of circuit 118, when it is functioning as part of OCD circuitry, is as follows. In Figure 6, the transconductance means are shown as NMOS transistors 213a, 213b. Reference voltage Vref is set to a relatively low value compared to a normal operational range, for example at about 10% of the power supply voltage. Multiplexer 35 connects drain terminal 227a to an external sensor (e.g. sensor 31, 32, 33) via pin 116. Amplifier 112 will then try to force, or control, gate terminals 228a, 228b such that voltage at second input 121 is the same as Vref, whereby in effect it tries to pull the voltage on pin 116 down (a "pull down test"). If the connection is operating correctly, for example a signal is carried on the connection without disruption or disconnection, then the voltage on pin 116 will not change much (in other words, only small variance in the voltage can be observed when monitoring), if at all. Therefore, the current in NMOS transistors 213a, 213b will reach a maximum. The maximum current is arranged such that it is higher than a reference current from current source 214. This means that an input to one or more amplifier 229 (which functions as an inverter chain) is pulled low, and the output signal at output 125 is hence set low. This indicates there is no fault or disruption in the electrical connection from an open circuit.

If however there is an open circuit on pin 116, then very little injected current is required to move the voltage on pin 116. The current in NMOS transistor 213b is low because not much current in NMOS transistor 213a is needed to move the voltage at input 121 of amplifier 112, and the input to one or more amplifier 229 (which functions as an inverter chain) is pulled high by the greater reference current from current source 214. The output signal at output 125 is set high, indicating an open circuit fault or disruption.

If however, the voltage on pin 116 is normally very small, for example near or at zero volts, then trying to pull the voltage lower as described above will fail because an outcome of performing the pull down test cannot be a reliable indication for detecting an open circuit. Therefore, an open circuit cannot be differentiated from correctly operating connection. To test for an open circuit in such scenario, the voltage on pin 116 must instead be pulled high (a "pull up test"). This requires a second circuit, similar to circuit 118, but configured differently to source a current, rather than sink one. An example of such a second circuit is circuit 118b illustrated in Figure 7, which is described below.

Figure 7 illustrates a further example in which one or more circuitry operable to obtain measurements of one or more pins comprise first circuit 118a for monitoring current and second circuit 118b for monitoring current. First circuit 118a is identical to circuit 118 in Figure 6. For example, reference voltage Vref of first circuit 118a may be set to a relatively low value compared to a normal operational range, for example, at about 10% of the power supply voltage. Second circuit 118b operates in a similar way, but with the following differences which means it performs a pull up test, instead of a pull down test performed by first circuit 118a. Reference voltage Vref of second circuit 118b may be set at higher value, for example, at about 90% of the power supply voltage. The transconductance means are implemented as PMOS transistors, which source a current into pin 116 and an input to the amplifier. The connection between current sink 214b (which may be equivalent to current source 214a in first circuit 118a but now behaving as a sink, not a source), and PMOS transistor is forced low if there is an open circuit. Only one amplifier functioning as an inverter is present, such that signal at output 125b is forced high on an open circuit.

One or more circuitry in Figure 7 cannot perform both the pull up and pull down test on the same pin at the same time. Thus, at any given time, only one of first circuit 118a and second circuit 118b is electrically connected to the same pin by multiplexer 35. Note that, when performing the pull up test and the pull down test on the same pin, although in Figure 7 shows outputs 125a and 125b both as being connected directly to logical AND element 126 via separate inputs, logical AND element 126 will receive signals from outputs 125a and 125b at different times, and hence AND operation will be performed on inputs with a time delay therebetween. This may then require the inputs to logical AND element 126 to be latched, or the AND operation to be conducted by a device with a memory, for instance a processor.

To completely detect an Open Circuit from a voltage on a pin, both a pull down test and a pull up test must be carried out on that pin. Typically, these two tests will be performed when the one or more circuitry's operation does not interfere with other functions of the battery system, for example obtaining sensor measurements from one or more external sensor (such as sensor 31, 32, 33) connected to that pin 116. In some examples, one or more controllers described herein may schedule or synchronise such pull down test and pull up test so that they are not performed when that pin 116 is used to carry a signal or data for other functions of the battery system.

It is understood that other ways of operating the one or more circuitry in Figure 7 may be used to detect an open circuit. For example, multiplexer 35 may be controlled so that: at a particular moment in time, first circuit 118a performs its pull down test on a first pin, and second circuit 118b performs its pull up test on a second pin, different from the first pin, and the output signals at outputs 125a, 125b are stored on a memory; and at another moment in time, first circuit 118a performs its pull down test on the second pin, and second circuit 118b performs its pull up test on the first pin, and the output signals at outputs 125a, 125b and the stored output signals from the previous moment in time are used as inputs to logical AND element 126 to detect an open circuit. It is understood that yet other modified ways of detecting an open circuit may be implemented using the one or more circuitry in Figure 7.

In the example illustrated in Figure 7, first circuit 118a for measuring current and second circuit 118b for measuring current comprise a pair of n-type field effect transistors and a pair of p-channel field effect transistors. However, it is understood that other types of transconductance means may be used in first circuit 118a and in second circuit 118b, depending on the operations (e.g., pull up or pull down tests) circuits 118a, 118b are designed to perform.

Figure 8 illustrates an example of one or more circuitry 418 which differs from the example provided in Figure 7 in that first circuit for monitoring current (for pulling the voltage on pin 116 high) and second circuit for monitoring current (for pulling the voltage on pin 116 low) share the same circuit 417 for amplifying variance. In this example, first variable current source 214a is in electrical connection with drain terminal of second field effect transistor 213b, and second variable current source 214b is in electrical connection with drain terminal of fourth field effect transistor 413b. Switches 417a, 417b, 417c, 417d are configured to operate one or more circuitry 418 to either pull up or pull down. In the example circuits for monitoring current illustrated in Figure 8, drain terminal of third field effect transistor 413a is in electrical connection with second input 121 of differential amplifier 112. Output 122 of differential amplifier 112 is in electrical connection with gate terminals of third and fourth field effect transistors 413a, 413b when switch 417c is closed. Output 122 of differential amplifier 112 is in electrical connection with gate terminals of first and second field effect transistors 213a, 213b when switch 417b is closed. Thus, if first switch 417a and second switch 417b are closed, then one or more circuitry 418 pulls down the voltage on pin 116. If third switch 417c and fourth switch 417d are closed, then one or more circuitry 418 pulls up the voltage on pin 116. In some examples, a controller may be provided to control the opening and closing of switches 417a, 417b, 417c, 417d to configure one or more circuitry 418 to either pull up or pull down.

### Short circuit detection (SCD) according to some exemplary embodiments

In some examples, the open circuit detection process (e.g., pull up or pull down test) described above is carried out on a first pin, while making a measurement of a voltage on a second pin that is different from the first pin. As the open circuit detect process is carried out on the first pin, the measurement on the second pin may be compared to determine a presence of a short circuit between the first and second pins. If the voltage measurement on the second pin also changes as the first pin's voltage is either pulled up or down, then this indicates that there may be a short circuit between these pins.

### Alternatives for transconductance means

The transconductance means in circuitries in Figure 6 to Figure 8 comprise at least one transistor. In some examples, such at least one transistor comprises at least one field-effect transistor and/or at least one bipolar transistor. Such at least one field-effect transistor may comprise at least one n-type transistor and/or at least one p-type transistor.

### Effect of Impedance on circuit for monitoring current

If above-described example circuits for monitoring current are connected to a high impedance (for example, a pin of a pressure sensor), then the open circuit detection functionality of the circuit may have less utility than the short circuit detection functionality. Alternatively, if such circuits for monitoring current are in electrical connection with a low impedance (such as a pin of a current shunt or cell voltage), then the short circuit detection functionality of the circuit may have less utility than the open circuit detection functionality of the circuit.

### Method of enabling open or short circuit detection according to some exemplary embodiments

In some examples of a method of enabling open or short circuit detection, at least one circuit for monitoring current is provided in a component of a battery system described herein, wherein the circuit for monitoring current is operable to provide an output signal for detecting an open circuit or a short circuit, which may then be used to detect a disruption to, or a fault in, a signal communication path in the battery system. Such disruption or fault may be caused by a faulty pin, for example. For example, the at least one circuit may be any of circuits 118, 118a, 118b, 418 in Figure 6 to Figure 8.

The method comprises: providing first element for establishing electrical connection between one voltage reference and a first input of a different amplifier of at least one other circuit for amplifying variance, wherein the differential amplifier further comprises a second input and an output; providing second element for establishing electrical connection between the second input of the differential amplifier and at least one output of at least one transconductance means; providing third element for establishing electrical connection between at least one input of the at least one transconductance means and the output of the differential amplifier, wherein the second input of the differential amplifier and at least one output of the at least one transconductance means are capable of being configured to be in electrical connection with one or more pins of the battery system; providing fourth element for establishing electrical connection between at least one current source and at least one output of at least one of the at least one transconductance means; and providing fifth element for establishing electrical connection between an output of the at least one circuit for monitoring current and at least one output of at least one of the at least one transconductance means. In some examples, the first element, the second element, the third element, the fourth element, and the fifth element are provided on a semiconductor material, and/or in an integrated circuit (IC) chip. In some examples, at least some of the first element, the second element, the third element, the fourth element, and the fifth element are provided on a printed circuit board (PCB) or a printed wiring board (PWB). Preferably, the first element, the second element, the third element, the fourth element, and the fifth element comprise conductive components with an exposed surface for establishing electrical connection.

In some examples, the method may further comprise providing the at least one circuit for monitoring current in a monitoring device described herein, wherein the monitor device is operable to report sensor measurements in the battery system, and wherein the monitoring device comprises one or more circuitry operable to obtain measurements of the one or more pins of the battery system, and the one or more circuitry comprise the at least one circuit for monitoring current.

In some other examples, the method may further comprise establishing (for example, by physically connecting through soldering or by controlling one or more switch to establish electrical contact) electrical connections using the first element, the second element, the third element, the fourth element, and the fifth element, whereby the at least one circuit for monitoring current is operable to generate an output signal for detecting an open circuit or a short circuit, which may then be used to detect a disruption to, or an absence of, an electrical connection of a sensor connected to one or more pins of the battery system by monitoring a current required to cause a variance in a voltage on the one or more pins. For example, the output signal may indicate a disruption to, or an absence of, an electrical connection of a sensor connected to the one or more pins.

### Power on Reset

Circuits on Application Specific Integrated Circuits (ASIC) are typically designed using libraries of standard components. For instance, rather than the ASIC designer having to design a flip-flop circuit, the ASIC manufacturer will provide a previously verified design for a flip flop for all designers to use. There will be many such parts, which are combined into a standard library of parts. A selection of these standard parts are then combined by the ASIC designer into a core circuit to perform whatever functions the ASIC needs to do, for instance as a processor. For example, the core circuit may be designed or arranged to perform some or all of the functions or functionalities described herein as being performed by circuitry, a device or a processor. In some examples, one or more components of a system or a device described herein are implemented with ASIC.

The standard library will be specified to operate over a well-defined voltage range. For instance, the library may be defined to operate over the voltage range 1.10V to 1.30V. Inside this range, the library parts are guaranteed to operate as defined. Outside this range, operation is not guaranteed. For instance, the part may operate too slowly if the voltage is too low, or the example flipflop may not retain its state. If the voltage is too high, then the parts may switch too fast, leading to timing problems, or the parts may age too quickly.

Circuits need to operate properly, or at least in a predictable manner, especially in safety critical systems such as those required for functional safety. It is useful to have state of circuit known at all times, rather than being in an unknown and therefore potentially unsafe state. The circuit power supply should deliver a supply voltage within the specified range if the core circuit is to operate correctly. To provide certainty or at least predictability, if the voltage is outside the specified range, then the core circuit may be forced into a known 'reset' state, where it is not operational, but is known to be safe.

The most common situation where this occurs is when the core circuit is being powered up. The circuit will start with a zero supply voltage. As the voltage increases it will initially be too low, and the circuit must be kept in a reset state. Eventually it will come into the specified range and the circuit can be allowed to leave the reset state and start normal operation.

The function of forcing the reset state is performed by a Reset Circuit. The Reset Circuit, often called a Power On Reset or POR circuit, sends a signal to the core circuit. When asserted, this signal forces the core circuit into the reset state. When unasserted, the core circuit is allowed to leave the reset state in a defined manner. A typical reset circuit measures the supply voltage, and when it reaches a high enough level, the reset signal is unasserted.

Typically, the power supply is applied very quickly, for example in a time usually much less than a second. An ASIC may have a specification for how quick the power supply voltage must rise, for instance it may specify that the supply voltage must reach the specified range in less than 1ms.

Some circuitries will start operating immediately when the voltage is high enough, for instance clock generator or oscillators. The clock generator will also need to be operational before the core circuit can operate correctly. The clock generator requires a certain amount of time to settle, for example, 10ms. There may be other circuitry that also takes an amount of time to settle and become fully operational.

For this reason, the POR circuit usually has a time delay before the reset signal is unasserted, longer than the time taken for the slowest circuit to settle. In the above case, for example, this time delay may be set at 50ms, giving plenty of time for the clock generator to settle into proper operation. Thus, the core circuit is allowed out of the reset state only when the supply voltage is in the specified range and has been in range for longer than a (predefined) time period.

In some examples, a Cell Monitoring Device (CMD) described herein may be implemented with a type of ASIC. Such a CMD comprises a core circuit built from standard library parts and performs a safety function requiring that the core circuit is always in a known state. A CMD attached to a battery cell will be powered from the battery cell. If the CMD is attached to the cell when its voltage is lower than the minimum specified voltage, then the core circuit on the CMD will be held in reset, and kept there until the cell voltage has risen high enough for the CMD power supplies to provide a supply voltage in the specified range.

Unlike a more typical application where the power supply is switched on, on a CMD attached to a cell the power supply is always connected and almost permanently on until the cell runs out of power so the supplied power may change only very slowly. The cell voltage will usually increase only when the cell is being charged.

One special case is when the CMD is attached to a cell while it is being manufactured. Initially, the cell is at zero volts. The cell then undergoes a 'formation charge', where the cell is charged at a certain rate that allows the necessary electrochemical processes to occur in the cell. A formation charge may take many hours or even days to perform.

Thus, the supply voltage is increased not in 1ms, or even 1s, but instead over many hours. This very slow ramping cause problems with normal POR circuits, as the circuit cannot implement a time delay (of any practical length) to ensure all circuits are in the specified range and can be operational before the POR time delay expires.

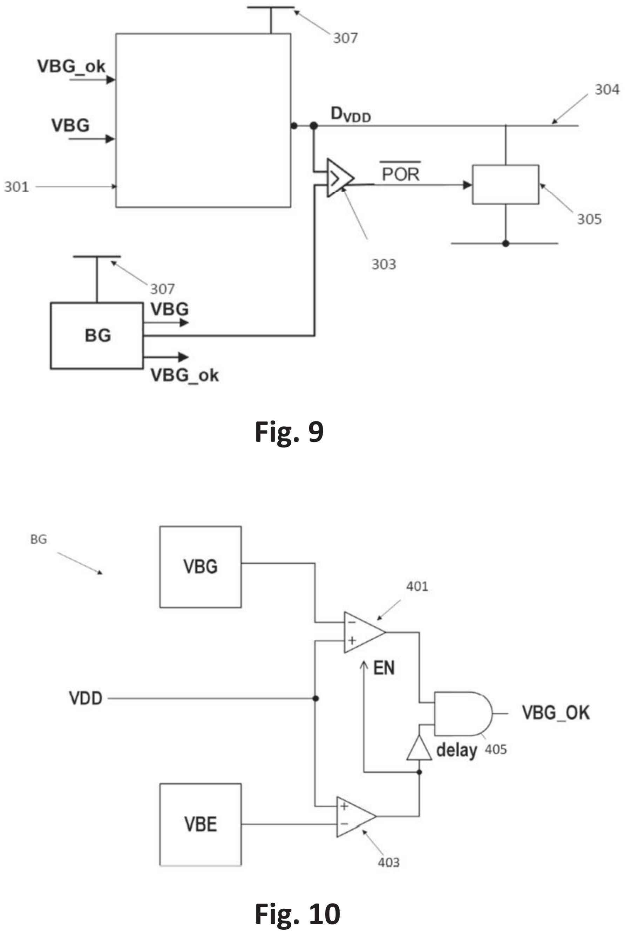

Thus, some of the example embodiments presented herein are directed towards a regulation system which provides power on reset to CMD core circuitry (for example, core circuitry in cell monitoring device 10, 10-1...10-N described herein) in a defined state in an efficient manner, thereby eliminating the need for time delays on POR. Figure 9 illustrates an example electronics regulation system for regulating voltage to be supplied to core logic of CMD 305 within an electric battery system during a power on reset (POR). The system comprises voltage regulation unit 301, bandgap reference unit (BG), and power on reset comparator 303.

In operation, CMD may be functional once a supplied voltage level to CMD core circuitry 305 is in the range of, for example, 1.1 to 1.3 volts. Power supply 307 may be configured to supply a voltage (VDD) to the regulation system during a power on reset within the range of 0 to 5 volts. The electronics regulation system may generate a regulated voltage (D_{VDD}) based on a bandgap voltage (VBG) reference, which is provided by bandgap reference unit (BG), and enable the core circuit of CMD 305 once the regulated voltage has reached a threshold to provide functionality in a safe manner (e.g., 1.1v-1.3v).

First, the voltage (VDD) supplied by the power supply 307 will activate the bandgap reference unit (BG). The bandgap reference unit (BG) is configured to enable voltage regulation unit 301 by providing an enablement signal (VBG_ok) to the voltage regulation unit 301. The bandgap reference unit (BG) is further configured to supply stable bandgap voltage reference (VBG) to voltage regulation unit 301 and the power on reset comparator 303. Once being enabled by bandgap reference unit (BG), voltage regulation unit 301 is configured to generate regulated voltage (D_{VDD}) based on a comparison of the bandgap reference voltage (VBG). Voltage regulation unit 301 is further configured to provide regulated voltage (D_{VDD}) to the power on reset comparator 303. The power on reset comparator will enable CMD 305 to receive regulated voltage (D_{VDD}) via power supply line 304.

In some examples, Bandgap reference unit (BG) is a temperature independent voltage reference circuit which produces a fixed and constant voltage regardless of variations resulting from the power supply, temperature changes or circuit loading. An example configuration of bandgap regulation unit (BG) is provided in Figure 10. The bandgap reference unit (BG) comprises first comparator 401 and second comparator 403, where second comparator 403 is configured to enable the operations of first comparator 401.

Supply voltage (VDD) is provided as an input to second comparator 403. Second comparator 403 is further configured to receive a base emitter voltage (VBE) reference as an input. Base emitter voltage (VBE) reference voltage generator may be used in the form of a bipolar device used as a reference for second comparator 403. According to some of the example embodiments, prior to being provided to second comparator 403, the supply voltage (VDD) may be input to a divided reference in order to ensure the magnitude of the voltage being evaluated by second comparator 403 is within the operational range of second comparator 403.

Second comparator 403 may be used to detect when supply voltage (VDD) is greater than the VBE reference voltage. Once the supply voltage has reached a level greater than the VBE reference voltage, second comparator 403 will send an enablement signal (EN) to first comparator 401, thereby enabling the operations of first comparator 401. A true logic signal will also be sent to an AND logical element 405 once the supply voltage reaches a level which is greater than the VBE reference voltage.

First comparator 401 is configured to receive supply voltage (VDD) and a generated bandgap voltage reference (VBG) as inputs. It should be appreciated that a divided supply voltage (VDD) may also be input to first comparator 401 to ensure the magnitude of the voltage being evaluated by second comparator 403 are within the operational range of second comparator 403. Upon receiving the enablement signal (EN) from second comparator 403, first comparator 401 will be able to compare the supply voltage (VDD) to the bandgap voltage (VBG) reference. Once the supply voltage (VDD) reaches a level above bandgap voltage (VBG) reference, first comparator 401 will send a logic true signal to logical AND element 405.

Under typical process and temperature conditions it is possible that first comparator 401, with bandgap voltage (VBG) reference and supply voltage (VDD) as inputs, is sufficient to indicate when the bandgap is close to a steady state output voltage. For example, assuming a value of ~1V at minimum VDD operation, when bandgap voltage (VBG) reference > 1.0V, enablement signal (VBG_ok) will flag thereby indicating supply voltage (VDD) is guaranteed to be > 1.0V.

The problem with this solution is that as supply voltage (VDD) ramps under non ideal conditions (hot/cold temp, slow/fast silicon), it is possible that bandgap voltage (VBG) reference may exceed this threshold then fall back to 0V as supply voltage (VDD) ramps. Under these conditions enablement signal (VBG_ok) will flag high then low for (potentially) multiple VDD voltages and this could cause start-up issues in subsequent circuitry.

To address such issues, second comparator 403 is used between supply voltage (VDD) and base emitter voltage (VBE) reference. The intention of this circuit portion is to indicate when supply voltage (VDD) is above a minimum voltage. This voltage threshold is chosen to be the minimum value of supply voltage (VDD) which guarantees the bandgap voltage (VBG) reference does not fall back to 0V. This may be found from process-voltage-temperature (PVT) simulations. In other words, for ramping supply voltage (VDD) this circuit portion will indicate when the bandgap will be stable if powered up. It should be appreciated that base emitter voltage (VBE) reference may be configured to be equal to the determined minimal threshold voltage which guarantees bandgap voltage (VBG) will not fall back to 0V.

When this supply voltage (VDD) threshold voltage (e.g., base emitter voltage (VBE) reference) is reached, second comparator 403 is used to enable first comparator 401 which subsequently detects if the (stable) bandgap has actually powered up. According to some of the example embodiments, it is useful to use second comparator 403 in addition to first comparator 401 because, for example, for fast VDD ramping first comparator 401 may glitch, causing erroneous VBG_ok signals. To stop this behaviour a small delay (delay) may be added between first comparator 401 power up and VBG_ok being active. The amount of delay required may be characterised in simulation across PVT for fast VDD ramping. An example of such a delay may be in the order of nanoseconds.

Logical AND element 405 will receive two logic true signals as input once first and second comparators 401, 403 detect the supply voltage being greater than the bandgap voltage (VBG) reference and the base emitter voltage (VBE) reference, respectively. Once the inputs to logical AND element 405 are both true signals, element 405 is configured to send an enablement signal (VBG_ok) to the voltage regulator 301, thereby enabling operation of regulator 301.

A voltage regulator is configured to generate a fixed output voltage of a preset magnitude that remains constant regardless of changes to its input voltage or load conditions. Voltage regulator 301 will generate regulated voltage (D_{VDD}) using bandgap voltage (VBG) reference as a baseline or comparison. According to some of the example embodiments, voltage regulation unit 301 may be a low-dropout (LDO) regulator or any other voltage regulator capable of generating an output voltage that is regulated to be of a preset magnitude.

The regulated voltage (D_{VDD}) is provided to a supply rail 304 used by core circuitry of CMD 305 and is further supplied to POR comparator 303. Once a value of the regulated voltage (D_{VDD}) is greater than a value of bandgap voltage (VBG) reference, POR comparator 303 will provide a further enablement signal (POR) to core circuitry of CMD 305. Enablement signal POR alerts core circuitry of CMD 305 the ramped supply voltage (VDD) has reached a level of operational safety. Core circuitry of CMD 305 thereafter uses the regulated voltage (D_{VDD}) from supply rail 304 as power supply, for example, for its operation.

The description of the example embodiments provided herein have been presented for purposes of illustration. The description is not intended to be exhaustive or to limit example embodiments to the precise form disclosed, and modifications and variations are possible in light of the above teachings or may be acquired from practice of various alternatives to the provided embodiments. The examples discussed herein were chosen and described in order to explain the principles and the nature of various example embodiments and its practical application to enable one skilled in the art to utilize the example embodiments in various manners and with various modifications as are suited to the particular use contemplated. The features of the embodiments described herein may be combined in all possible combinations of methods, apparatus, modules, systems, and computer program products. It should be appreciated that the example embodiments presented herein may be practiced in any combination with each other.

It should be noted that the word "comprising" does not necessarily exclude the presence of other elements or steps than those listed and the words "a" or "an" preceding an element do not exclude the presence of a plurality of such elements. It should further be noted that any reference signs do not limit the scope of the claims, that the example embodiments may be implemented at least in part by means of both hardware and software, and that several "means", "units" or "devices" may be represented by the same item of hardware.

The various example embodiments described herein are described in the general context of method steps or processes, which may be implemented in one aspect by a computer program product, embodied in a computer-readable medium, comprising computer-executable instructions, such as program code, executed by computers in networked environments. A computer-readable medium may comprise removable and non-removable storage devices comprising, but not limited to, Read Only Memory (ROM), Random Access Memory (RAM), compact discs (CDs), digital versatile discs (DVD), etc. Generally, program modules may comprise routines, programs, objects, components, data structures, etc. that perform particular tasks or implement particular abstract data types. Computer-executable instructions, associated data structures, and program modules represent examples of program code for executing steps of the methods disclosed herein. The particular sequence of such executable instructions or associated data structures represents examples of corresponding acts for implementing the functions described in such steps or processes.

It is to be understood that processors 39, 52 described herein may be implemented using at least one processing unit (or at least one core) and one or more internal registers. It is also to be understood that processors 39, 52 described herein may be implemented using circuitry configured to perform the operations described herein.

Various embodiments are described herein with reference to systems, methods, processes, devices, or computer readable media. It is intended that the disclosure of one is a disclosure of all. For example, it is to be understood that disclosure of a computer readable medium described herein also constitutes a disclosure of methods implemented using the computer readable medium, and systems and devices for implementing those methods, via for example, at least one processor or a circuitry configured to implement those methods. It is to be understood that this form of disclosure is for ease of discussion only, and one or more aspects of one embodiment herein may be combined with one or more aspects of other embodiments herein, within the intended scope of this disclosure.

In the drawings and specification, there have been disclosed example embodiments. However, many variations and modifications can be made to these embodiments. Accordingly, although specific terms are employed, they are used in a generic and descriptive sense only and not for purposes of limitation, the scope of the embodiments being defined by the following claims.

Embodiments of the present disclosure may be described with respect to the following clauses:
1. A monitoring device operable to report sensor measurements in a battery system, the monitoring device comprising:
   one or more circuitry operable to obtain measurements of one or more pins of a battery system, the one or more circuitry comprising:
   at least one circuit for monitoring current comprising:
   at least one other circuit for amplifying variance comprising at least one differential amplifier, one voltage reference in electrical connection with a first input of the differential amplifier, the differential amplifier further comprising a second input and an output;
   at least one transconductance means comprising at least one output in electrical connection with the second input of the differential amplifier and at least one input in electrical connection with the output of the differential amplifier;
   wherein the second input of the differential amplifier and at least one output of the at least one transconductance means is in electrical connection with the one or more pins of a battery system;
   at least one current source in electrical connection with at least one output of at least one of the at least one transconductance means; and
   an output in electrical connection with at least one output of at least one of the at least one transconductance means;
   wherein the at least one circuit for monitoring current is operable to detect a disruption to, or an absence of, an electrical connection of a sensor connected to the one or more pins by monitoring a current required to cause a variance in a voltage on the one or more pins.
2. A monitoring device according to clause 1, wherein the at least one transconductance means comprises at least one transistor.
3. A monitoring device according to clause 2, wherein the at least one transistor comprises at least one pair of p-channel or n-type field effect transistors.
4. A monitoring device according to clause 3, wherein the at least one pair of p-channel or n-type field effect transistors comprises a first field effect transistor and a second field effect transistor, each comprising a source terminal, a drain terminal, and a gate terminal, wherein the first field effect transistor and the second field effect transistor are arranged in parallel such that their respective gate terminals are in electrical connection with each other and their respective source terminals are in electrical connection with each other.
5. A monitoring device according to clause 4, wherein the output of the differential amplifier is in electrical connection with the gate terminals of the pair of field effect transistors.
6. A monitoring device according to clause 5, wherein the drain terminal of the first field effect transistor is in electrical connection with the second input of the differential amplifier.
7. A monitoring device according to clause 6, wherein the at least one current source is in electrical connection with the drain terminal of the second field effect transistor.
8. A monitoring device according to any preceding clause, wherein the at least one current source comprises a variable current source.
9. A monitoring device according to any preceding clause, wherein the at least one circuit for monitoring current comprises a first circuit for monitoring current and a second circuit for monitoring current, wherein the first circuit for measuring current comprises p-channel field effect transistors and the second circuit for measuring current comprises n-type field effect transistors.
10. A monitoring device according to any preceding clause, wherein the circuit for monitoring current further comprises at least one output amplifier arranged at the output of the circuit.
11. A monitoring device according to any preceding clause, wherein the at least one circuits for monitoring current are in electrical connection with the one or more pins of the battery system via a multiplexer.
12. A monitoring device according to any preceding clause, wherein the current source provides a reference current.
13. A monitoring device according to any preceding clause, wherein the one or more circuitry operable to obtain measurements of one or more pins of a battery system comprises at least a first circuit operable to detect an open circuit on a first pin, and a second circuit operable to identify a variance in a voltage on a second pin, wherein the monitoring device is operable to detect a short circuit when a variance is identified in the voltage on the second pin.
14. A regulation system for providing a regulated voltage during a power on reset to a cell monitoring device, CMD of an electric battery system, wherein the electric battery system comprises at least one pack, each pack comprising a plurality of battery cells, wherein each battery cell is monitored via a respective CMD, the regulation system comprising:
   a bandgap reference unit (BG) configured to generate a bandgap reference voltage (VBG) based on a supply voltage (VDD), and further configured to generate a first enablement signal (VBG_ok) once the bandgap reference voltage (VBG) is stable and at a level suitable for operational safety of the CMD core circuit (305);
   a voltage regulator unit (301) configured to receive the bandgap reference voltage (VBG) and the first enablement signal (VGB_ok) from the bandgap reference unit, and upon receipt of the first enablement signal, the voltage regulation unit further configured to generate the regulated voltage (D_{VDD}), for powering the CMD core circuit (305), wherein the regulated voltage (D_{VDD}) is generated based on a comparison of the bandgap reference voltage (VBG); and
   a power on reset comparator (303) configured to receive the bandgap reference voltage (VBG) from the bandgap reference unit (BG) and the regulated voltage (D_{VDD}) from the voltage regulator, wherein the power on reset comparator (303) is further configured to provide a second enablement signal (POR) to the CMD core circuit 305 once a value of the regulated voltage (D_{VDD}) is greater than a value of the bandgap reference voltage (VBG), wherein the second enablement signal (POR) enables the CMD core circuit to access the regulated voltage (D_{VDD}).
15. A regulation system according to clause 14, wherein the bandgap reference unit (BG) comprises:
   a first comparator (401) configured to receive the supply voltage VDD and the generated bandgap voltage reference (VBG) as input;
   a second comparator (403) configured to receive the supply voltage VDD and a base emitter voltage (VBE) reference as input;
   wherein the second comparator (403) is configured to enable operations of the first comparator (401) and provide a logic true to a logical AND element (405) once the second comparator detects the supply voltage (VDD) is greater than the base emitter voltage (VBE) reference;
   wherein the first comparator (401), upon being enabled via the second comparator (403), is configured to send a logic true to the logical AND element (405) once the first comparator detects the supply voltage (VDD) is greater than the bandgap voltage (VBG) reference; and
   the logical AND element (405) is configured to provide the first enablement signal (VBG_ok) to the voltage regulator unit (301) and the generated bandgap voltage (VBG) to the power on reset comparator (303) once the inputs of the logical AND element are both true.
16. A method in a regulation system for providing a regulated voltage during a power on reset to a cell monitoring device, CMD of an electric battery system, wherein the electric battery system comprises at least one pack, each pack comprising a plurality of battery cells, wherein each battery cell is monitored via a respective CMD, the method comprising:
   generating, via a bandgap reference unit (BG), a bandgap reference voltage (VGB) based on a supply voltage (VDD), and further generating a first enablement signal (VBG_ok) once the bandgap reference voltage (VBG) is stable and at a level suitable for operational safety of the CMD core circuit (305);
   receiving, via a voltage regulator unit (301), the bandgap reference voltage (VBG) and the first enablement signal (VGB_ok) from the bandgap reference unit;
   upon receipt of the first enablement signal, generating, via the voltage regulator unit, the regulated voltage (D_{VDD}) for powering the CMD core circuit (305), wherein the regulated voltage (D_{VDD}) is generated based on a comparison of the bandgap reference voltage (VBG); and
   receiving, via a power on reset comparator (303), the bandgap reference voltage (VBG) from the bandgap reference unit (BG) and the regulated voltage (D_{VDD}) from the voltage regulator;
   providing, via the power on reset comparator, a second enablement signal (POR) to the CMD core circuit (305) once a value of the regulated voltage (D_{VDD}) is greater than a value of the bandgap reference voltage (VBG), wherein the second enablement signal (POR) enables the CMD core circuit to access the regulated voltage (D_{VDD}).
17. A method according to clause 16, further comprising:
   receiving, via a first comparator (401), the supply voltage VDD and the generated bandgap voltage reference (VBG) as input;
   receiving, via a second comparator (403), the supply voltage VDD and a base emitter voltage (VBE) reference as input;
   enabling operations, via the second comparator (403), of the first comparator (401) and providing a logic true to a logical AND element (405) once the second comparator detects the supply voltage (VDD) is greater than the base emitter voltage (VBE) reference;
   upon being enabled, sending, via the second comparator (403), a logic true to the logical AND element (405) once the first comparator detects the supply voltage (VDD) is greater than the bandgap voltage (VBG) reference; and
   providing, via the logical AND element (405), the first enablement signal (VBG_ok) to the voltage regulator unit (301) and the generated bandgap voltage (VBG) to the power on reset comparator (303) once the inputs of the logical AND element are both true.

## Claims

1. A regulation system for providing a regulated voltage during a power on reset to a cell monitoring device, CMD, of an electric battery system, wherein the electric battery system comprises at least one pack, each pack comprising a plurality of battery cells, wherein each battery cell is monitored via a respective CMD, the regulation system comprising:
a bandgap reference unit (BG) configured to generate a bandgap reference voltage (VBG) based on a supply voltage (VDD), and further configured to generate a first enablement signal (VBG_ok) once the bandgap reference voltage (VBG) is stable and at a level suitable for operational safety of the CMD core circuit (305);
a voltage regulator unit (301) configured to receive the bandgap reference voltage (VBG) and the first enablement signal (VGB_ok) from the bandgap reference unit, and upon receipt of the first enablement signal, the voltage regulation unit further configured to generate the regulated voltage (D_{VDD}), for powering the CMD core circuit (305), wherein the regulated voltage (D_{VDD}) is generated based on a comparison of the bandgap reference voltage (VBG); and
a power on reset comparator (303) configured to receive the bandgap reference voltage (VBG) from the bandgap reference unit (BG) and the regulated voltage (D_{VDD}) from the voltage regulator, wherein the power on reset comparator (303) is further configured to provide a second enablement signal (POR) to the CMD core circuit 305 once a value of the regulated voltage (D_{VDD}) is greater than a value of the bandgap reference voltage (VBG), wherein the second enablement signal (POR) enables the CMD core circuit to access the regulated voltage (D_{VDD}).

2. A regulation system according to claim 1, wherein the bandgap reference unit (BG) comprises:
a first comparator (401) configured to receive the supply voltage VDD and the generated bandgap voltage reference (VBG) as input;
a second comparator (403) configured to receive the supply voltage VDD and a base emitter voltage (VBE) reference as input;
wherein the second comparator (403) is configured to enable operations of the first comparator (401) and provide a logic true to a logical AND element (405) once the second comparator detects the supply voltage (VDD) is greater than the base emitter voltage (VBE) reference;
wherein the first comparator (401), upon being enabled via the second comparator (403), is configured to send a logic true to the logical AND element (405) once the first comparator detects the supply voltage (VDD) is greater than the bandgap voltage (VBG) reference; and
the logical AND element (405) is configured to provide the first enablement signal (VBG_ok) to the voltage regulator unit (301) and the generated bandgap voltage (VBG) to the power on reset comparator (303) once the inputs of the logical AND element are both true.

3. The regulation system of claim 2, wherein the base emitter voltage (VBE) reference is configured to be equivalent to a threshold voltage above which the bandgap voltage (VBG) will not fall back to 0V.

4. The regulation system of any preceding claim, further configured with a delay between the first comparator (401) and the bandgap voltage (VBG) being active.

5. The regulation system of any preceding claim, wherein the voltage regulator unit (301) is a low-dropout (LDO) regulator.

6. A method in a regulation system for providing a regulated voltage during a power on reset to a cell monitoring device, CMD, of an electric battery system, wherein the electric battery system comprises at least one pack, each pack comprising a plurality of battery cells, wherein each battery cell is monitored via a respective CMD, the method comprising:
generating, via a bandgap reference unit (BG), a bandgap reference voltage (VGB) based on a supply voltage (VDD), and further generating a first enablement signal (VBG_ok) once the bandgap reference voltage (VBG) is stable and at a level suitable for operational safety of the CMD core circuit (305);
receiving, via a voltage regulator unit (301), the bandgap reference voltage (VBG) and the first enablement signal (VGB_ok) from the bandgap reference unit;
upon receipt of the first enablement signal, generating, via the voltage regulator unit, the regulated voltage (D_{VDD}) for powering the CMD core circuit (305), wherein the regulated voltage (D_{VDD}) is generated based on a comparison of the bandgap reference voltage (VBG); and
receiving, via a power on reset comparator (303), the bandgap reference voltage (VBG) from the bandgap reference unit (BG) and the regulated voltage (D_{VDD}) from the voltage regulator;
providing, via the power on reset comparator, a second enablement signal (POR) to the CMD core circuit (305) once a value of the regulated voltage (D_{VDD}) is greater than a value of the bandgap reference voltage (VBG), wherein the second enablement signal (POR) enables the CMD core circuit to access the regulated voltage (D_{VDD}).

7. A method according to claim 7, further comprising:
receiving, via a first comparator (401), the supply voltage VDD and the generated bandgap voltage reference (VBG) as input;
receiving, via a second comparator (403), the supply voltage VDD and a base emitter voltage (VBE) reference as input;
enabling operations, via the second comparator (403), of the first comparator (401) and providing a logic true to a logical AND element (405) once the second comparator detects the supply voltage (VDD) is greater than the base emitter voltage (VBE) reference;
upon being enabled, sending, via the second comparator (403), a logic true to the logical AND element (405) once the first comparator detects the supply voltage (VDD) is greater than the bandgap voltage (VBG) reference; and
providing, via the logical AND element (405), the first enablement signal (VBG_ok) to the voltage regulator unit (301) and the generated bandgap voltage (VBG) to the power on reset comparator (303) once the inputs of the logical AND element are both true.
